# EUROPÄISCHE PATENTSCHRIFT

(11) **EP 2 673 595 B1**
(45) Veröffentlichungstag und Bekanntmachung des Hinweises auf die Patenterteilung: **02.08.2017**
(21) Anmeldenummer: 12718055.2
(22) Anmeldetag: 07.02.2012
(51) Int. Cl.: G01D 11/24, G01F 15/14

(54) **EXPLOSIONSGESCHÜTZTES GERÄT**
EXPLOSION-PROOF APPARATUS
APPAREIL ANTIDÉFLAGRANT

(30) Priorität: 09.02.2011 DE 102011010799
(43) Veröffentlichungstag der Anmeldung: 18.12.2013
(73) Patentinhaber: KROHNE Messtechnik GmbH, 47058 Duisburg (DE)
(72) Erfinder: LEHMKUHL, Jürgen, 46535 Dinslaken (DE); ANGERSTEIN, Peter, 46149 Oberhausen (DE); SCHULZE, Sebastian, 06484 Quedlinburg (DE); WEGEMANN, Uwe, 47443 Moers (DE)
(74) Vertreter: Gesthuysen Patent- und Rechtsanwälte
(86) Internationale Anmeldenummer: PCT/EP2012/000545
(87) Internationale Veröffentlichungsnummer: WO 2012/107208

(56) Entgegenhaltungen:
- EP-A2- 2 048 483
- DE-A1- 3 900 210
- DE-A1- 19 532 646
- DE-A1- 19 623 651
- DE-A1- 19 634 191
- DE-A1-102007 028 909
- "Explosionsfähige Atmosphäre - Teil 26: Betriebsmittel mit Geräteschutzniveau (EPL) Ga", DIN EN 60079-26:2007, Oktober 2007 (2007-10), XP008156562,

## Beschreibung

Die Erfindung betrifft ein explosionsgeschütztes Gerät mit einer druckfesten Kapsel, einer Elektronikeinrichtung und einer Signalempfangseinrichtung, wobei die Elektronikeinrichtung eigensicher ausgestaltet ist, die druckfeste Kapsel ein strahlungsdurchlässiges Prozessfenster aufweist und die Signalempfangseinrichtung innerhalb der druckfesten Kapsel angeordnet ist.

Mit einem explosionsgeschützten Gerät ist ein Gerät gemeint, das geeignet ist für den Betrieb in Bereichen mit einer explosionsfähigen Atmosphäre. Das strahlungsdurchlässige Prozessfenster ist durchlässig für wenigstens den bestimmten Bereich des elektromagnetischen Spektrums, den das explosionsgeschützte Gerät mit der Signalempfangseinrichtung empfangen kann. Insbesondere kann das strahlungsdurchlässige Prozessfenster durchlässig sein für elektromagnetische Strahlung, wie z. B. sichtbares Licht, Infrarot-, Mikrowellen-, Radar-, Röntgen-, Gamma- und UV-Strahlung. Ebenso ist es denkbar, dass das strahlungsdurchlässige Prozessfenster durchlässig ist für Strahlung, die aus Teilchen besteht, wie z. B. Alpha- und Betastrahlung. Diese Strahlung kann dann von der Signalempfangseinrichtung detektiert werden. Das explosionsgeschützte Gerät dient daher im Allgemeinen der Detektion von Strahlungssignalen, die von einem Prozess ausgehen, der auf der der Elektronikeinrichtung abgewandten Seite des strahlungsdurchlässigen Prozessfensters positioniert ist. Ein Strahlungssignal kann schon darin bestehen, dass die zu detektierende Strahlung vorhanden ist oder nicht. Ein Prozess kann beispielsweise ein Stoff oder Stoffgemisch in einem Aggregatzustand oder mehreren beliebigen Aggregatzuständen sein, dessen Eigenschaften, Anwesenheit oder Dynamik überwacht, bestimmt oder beeinflusst werden sollen.

Bestimmungen für die Konstruktion und Prüfung eigensicherer Betriebsmittel, die für die Verwendung in gasexplosionsgefährdeten Bereichen bestimmt sind, sowie für zugehörige Betriebsmittel, die für den Anschluss an eigensichere Stromkreise gedacht sind, die in solche Bereiche hineinführen, werden von der Norm EN 60079-11 "Explosionsfähige Atmosphäre - Teil 11: Geräteschutz durch Eigensicherheit "i" " festgelegt. Diese Norm gilt auch für elektrische Betriebsmittel oder Teile elektrischer Betriebsmittel, die sich außerhalb des gasexplosionsgefährdeten Bereiches befinden oder durch eine andere Zündschutzart nach EN 60079-0 geschützt sind, sofern die Eigensicherheit der elektrischen Stromkreise im gasexplosionsgefährdeten Bereich von der Auslegung und der Bauart dieser elektrischen Betriebsmittel oder von Teilen dieser Betriebsmittel abhängen kann.

Die Zündschutzart Eigensicherheit beruht auf der Begrenzung von elektrischer Energie innerhalb von Betriebsmitteln und Verbindungsleitungen, die einer explosionsfähigen Atmosphäre ausgesetzt sind, auf ein Niveau unterhalb dessen, bei dem eine Zündung entweder durch Funkenbildung oder Erwärmung hervorgerufen werden kann.

Eine weitere mögliche Schutzart ist die der druckfesten Kapselung. Bei dieser auch als "Ex-d" bezeichneten Zündschutzart wird der Explosionsschutz dadurch sichergestellt, dass eventuell innerhalb der Kapsel auftretende Explosionen durch die druckfeste Kapselung derart abgeschirmt werden, dass eine außerhalb der druckfesten Kapsel vorherrschende explosionsfähige Atmosphäre nicht entzündet wird. Durchführungen in der Kapselwand müssen daher zünddurchschlagsichere Spalten aufweisen. Auch darf die Oberflächentemperatur der Kapsel bei Auftreten eines zu erwartenden Fehlers nicht die Zündtemperatur der umgebenden explosionsfähigen Atmosphäre erreichen. Die Norm EN 60079-1 "Explosionsfähige Atmosphäre - Teil 1: Geräteschutz durch druckfeste Kapselung "d" " legt die Anforderungen an Betriebsmittel dieser Zündschutzart fest.

Ein vergleichbares Verkapselungsprinzip wie die Zündschutzart druckfeste Kapselung verfolgt die Zündschutzart Vergusskapselung, auch als "Ex-m" bezeichnet. Bei der Vergusskapselung werden Bauteile, die eine potentielle Zündquelle darstellen können, mit einer für diesen Anwendungszweck geeigneten Vergussmasse überzogen. Durch diese Maßnahme wird sichergestellt, dass die umgebende explosionsfähige Atmosphäre nicht mit diesen Bauteilen in Kontakt kommt. Auch bei der Zündschutzart Vergusskapselung darf die Oberflächentemperatur der Vergusskapselung bei Auftreten eines zu erwartenden Fehlers nicht die Zündtemperatur der umgebenden explosionsfähigen Atmosphäre erreichen. Die Norm EN 60079-18 "Explosionsfähige Atmosphäre - Teil 18: Geräteschutz durch Vergusskapselung "m" " legt die Anforderungen an Betriebsmittel dieser Zündschutzart fest.
Aus dem Stand der Technik bekannte Geräte sind entweder in lediglich einer Zündschutzart, wie z. B. druckfeste Kapselung "Ex-d" oder Eigensicherheit "Ex-i", ausgeführt oder weisen eine Mischform auf, bei der Teile des Geräts in einer ersten Zündschutzart und andere Teile des Geräts in einer anderen Zündschutzart ausgebildet sind.
Aus der DE 37 11 754 A1 ist ein explosionsgeschütztes magnetischinduktives Durchflussmessgerät bekannt, mit einem in eine Rohrleitung einbaubaren Armaturenrohr mit wenigstens einer Messelektrode im Rohrinnern und wenigstens einem der Messelektrode zugeordneten und mit dem Armaturenrohr verbundenen, explosionsgeschützt aufgebauten Elektromagneten, mit einer elektrischen Versorgungseinheit für die Stromversorgung der Magnetspulen und einer Auswerteelektronik und einem die Versorgungseinheit umfassenden Schutzgehäuse. Hier ist innerhalb des Schutzgehäuses die elektrische Versorgungseinheit von der eigensicheren Auswerteelektronik getrennt in einer eigenen explosionsgeschützt ausgebildeten Kapsel angeordnet, mit Kabeleingängen für die elektrische Zuleitung und Kabelausgängen für die Stromversorgung der Magnetspule und der Auswerteelektronik. Die DE 195 32 646 A1 offenbart ein explosionsgeschütztes Gerät mit einer druckfesten Kapsel, einer Elektronikeinrichtung und einer Signalempfangseinrichtung, wobei die druckfeste Kapsel ein strahlungsdurchlässiges Prozessfenster aufweist und wobei die Signalempfangseinrichtung und die Elektronikeinrichtung innerhalb der druckfesten Kapsel angeordnet sind.

Ein wesentlicher Nachteil, der sich aus dem Stand der Technik ergibt, ist, dass Verbindungen von einem Teil eines Geräts, der in einer ersten Zündschutzart ausgebildet ist, zu einem anderen Teil eines Geräts, der in einer anderen Zündschutzart ausgebildet ist, oft sehr aufwendig sind. Beispielsweise sind Kabeldurchführungen durch die Wandung einer druckfesten Kapsel besonders aufwendig, da die hierbei auftretenden Spalten zünddurchschlagsicher ausgeführt sein müssen. Des Weiteren sind für Verbindungen zwischen eigensicher ausgebildeten Teilen eines Geräts und anderen Teilen des Geräts, die in einer anderen Zündschutzart ausgebildet sind, Sicherheitsbarrieren erforderlich, damit die Eigensicherheit des eigensicher ausgebildeten Teiles des Geräts weiterhin gewährleistet ist.
Damit ist es die Aufgabe der Erfindung, ein explosionsgeschütztes Gerät anzugeben, das flexibel einsetzbar und kostengünstig ist.

Die zuvor hergeleitete und aufgezeigte Aufgabe ist, ausgehend von dem eingangs beschriebenen explosionsgeschützten Gerät, dadurch gelöst, dass die Elektronikeinrichtung innerhalb der druckfesten Kapsel angeordnet ist und die Signalempfangseinrichtung eigensicher ausgebildet ist.
Dadurch, dass die Elektronikeinrichtung innerhalb der druckfesten Kapsel angeordnet ist und die Signalempfangseinrichtung eigensicher ausgebildet ist, ist es möglich, dass das Gerät als Ganzes die Anforderungen zweier verschiedener Zündschutzarten erfüllt, nämlich die Anforderungen der Zündschutzart "Ex-d" und die Anforderungen der Zündschutzart "Ex-i". Daher kann das erfindungsgemäße explosionsgeschützte Gerät sowohl in Bereichen eingesetzt werden, die einen Explosionsschutz gemäß der Zündschutzart "Ex-d" erfordern, als auch in Bereichen, die einen Explosionsschutz gemäß der Zündschutzart "Ex-i" erfordern. Die Zündschutzart "Ex-i" findet vor allem in der chemischen Industrie Einsatz, wohingegen die Zündschutzart "Ex-d" eher in der Öl- und Gas-Industrie anzutreffen ist. Das erfindungsgemäße explosionsgeschützte Gerät eignet sich daher, ohne dass weitere Modifikationen notwendig sind, sowohl für den Einsatz in Bereichen, in denen die Zündschutzart "Ex-d" erforderlich ist, als auch in Bereichen, in denen die Zündschutzart "Ex-i" erforderlich ist. Dadurch ergeben sich erhebliche Einsparungen in der Produktion, da lediglich eine Bauform des explosionsgeschützten Geräts hergestellt werden muss, und nicht wie bisher zwei oder mehrere verschiedene Bauformen hergestellt werden müssen.

Darüber hinaus sind für Verbindungen zwischen der Elektronikeinrichtung und in der druckfesten Kapsel angeordneten Bauteilen keine aufwendigen Kabeldurchführungen durch die Wandung der druckfesten Kapsel mehr nötig, da die Elektronikeinrichtung innerhalb der druckfesten Kapsel angeordnet ist.

Gemäß der Erfindung ist außerdem vorgesehen, dass die Elektronikeinrichtung und/oder die Signalempfangseinrichtung einen Verguss aufweisen bzw. aufweist.
Über einen einfachen Verguss mit Vergussmasse hinausgehend ist es ebenso denkbar, alle oder einen Teil der innerhalb der druckfesten Kapsel angeordneten Bauteile des explosionsgeschützten Geräts mit einer Vergusskapselung zu versehen, d. h. dass sie der Zündschutzart "Ex-m" genügen. Durch eine Vergusskapselung aller oder eines Teils der innerhalb der druckfesten Kapsel angeordneten Bauteile des explosionsgeschützten Geräts wird erreicht, dass Teile des explosionsgeschützten Geräts oder das vollständige explosionsgeschützte Gerät zusätzlich den Anforderungen der Zündschutzart "Ex-m" genügen. Hierdurch ergeben sich vergleichbare Vorteile für den Einsatz des erfindungsgemäßen explosionsgeschützten Geräts in Bereichen mit unterschiedlichen Anforderungen an den Explosionsschutz, wie sie oben am Beispiel der Zündschutzarten "Ex-d" und "Ex-i" erläutert worden sind.
Selbstverständlich lässt sich das Prinzip, dass ein explosionsgeschütztes Gerät gemäß den Anforderungen mehrer Zündschutzarten zugleich ausgeführt ist, auch auf weitere Zündschutzarten ausdehnen. Die Erfindung zeichnet sich ferner dadurch aus, dass der Verguss den Innenraum der druckfesten Kapsel zumindest teilweise ausfüllt. Eine teilweise oder vollständige Füllung des Innenraums der druckfesten Kapsel mit Vergussmasse erhöht die Stabilität des gesamten explosionsgeschützten Geräts. Insbesondere sind die im Inneren der druckfesten Kapsel angeordneten Bauteile des explosionsgeschützten Geräts hierdurch besonders geschützt gegen ein Losrütteln durch Erschütterungen oder dergleichen.
Durch die Füllung des Innenraums der druckfesten Kapsel mit Vergussmasse wird das nicht vergossene Restvolumen der druckfesten Kapsel reduziert. Dies ist besonders vorteilhaft, da der maximal auftretende Explosionsdruck hierdurch verringert wird.
Eine vorteilhafte Weiterbildung der Erfindung sieht vor, dass das strahlungsdurchlässige Prozessfenster aus einem für die jeweils verwendete Strahlung transparentem Material besteht, welches insbesondere die Anforderungen der EN 60079-1 erfüllt, beispielsweise Keramik. Eine alternative Ausgestaltung der Erfindung sieht vor, dass das strahlungsdurchlässige Prozessfenster aus einem Trägermaterial und darin eingebrachten Signalleitungen besteht, wobei das Trägermaterial die strukturelle Integrität des strahlungsdurchlässigen Prozessfensters gewährleistet und der Abdichtung des explosionsgeschützten Geräts dient und die in dem Trägermaterial angeordneten Signalleitungen die verwendete Strahlung leiten. Ein Beispiel für eine derartiges strahlungsdurchlässiges Prozessfenster sind in eine Keramik eingebrachte Leiter von Koaxial- oder anderen Leitungen.

Gemäß einer besonders vorteilhaften Weiterbildung der Erfindung ist vorgesehen, dass das strahlungsdurchlässige Prozessfenster ein Glasfenster aufweist. Das Material Glas eignet sich besonders für das strahlungsdurchlässige Prozessfenster des erfindungsgemäßen explosionsgeschützten Geräts. Glas ist nicht nur in einem weiten Bereich des Spektrums der elektromagnetischen Strahlung durchlässig, sondern kann auch durch entsprechende Zusätze eingefärbt werden, d. h. für nicht verwendete Bereiche des Spektrums der elektromagnetischen Strahlung undurchlässig gemacht werden, so dass die Eigenschaften des strahlungsdurchlässigen Prozessfensters spezifisch an die Anwendung angepasst werden kann. Des Weiteren kann aus der großen Vielfalt bekannter Gläser das Glas mit den gewünschten Eigenschaften gewählt werden. Zudem ergeben sich durch die Verwendung von Glas für das strahlungsdurchlässige Prozessfenster auch überschaubare Materialkosten.

Bei einer bevorzugten Ausgestaltung der Erfindung ist vorgesehen, dass das Glasfenster ein metallverschmolzenes Glas aufweist.

Metallverschmolzene Gläser sind thermisch vorgespannte Spezialgläser für die Prozessbeobachtung. Bei der Herstellung wird eine Glasscheibe in einen Metallring eingeschmolzen und verbindet sich dauerhaft mit diesem. Unterschiedliche Wärmeausdehnungskoeffizienten von Glas und Metall bewirken einen homogenen Druckspannungszustand im gesamten Glaskörper. Ein Vorteil, der sich aus der Verwendung von metallverschmolzenem Glas für das strahlungsdurchlässige Prozessfenster ergibt, ist dass metallverschmolzene Gläser im Schadensfall lediglich Oberflächenrisse zeigen, aber ein Totalversagen in der Regel nicht eintritt.

Gemäß einer weiteren bevorzugten Ausgestaltung der Erfindung ist vorgesehen, dass die Elektronikeinrichtung einen Signalerzeuger aufweist. Mit einem Signalerzeuger lässt sich das erfindungsgemäße explosionsgeschützte Gerät auch aktiv betreiben. D. h. dass nicht nur Strahlung empfangen wird, die originär dem beobachten Prozess entstammt. Die Strahlungssignale, die von dem Signalerzeuger erzeugt und durch das strahlungsdurchlässige Prozessfenster in den Prozess gelangen, treten dort mit dem Prozess in Wechselwirkung und bewirken, dass Strahlung von dem Prozess ausgeht, die nach Passieren des strahlungsdurchlässigen Prozessfensters von der Signalempfangseinrichtung empfangen werden kann. Als Wechselwirkungsprozess kommen beispielsweise die Lumineszenzprozesse Fluoreszenz und Phosphoreszenz in Frage, aber auch Streuung, Reflektion und stimulierte Emission. Wesentlich ist, dass die Strahlungssignale, die in den Prozess gesandt werden, in welcher Form auch immer, ursächlich für die von der Signalempfangseinrichtung detektierte Strahlung sind.

Darüber hinaus ist es vorteilhaft, wenn die Elektronikeinrichtung eine Signalauswerteeinrichtung aufweist. Mit Hilfe einer Signalauswerteeinrichtung kann die von dem Prozess ausgehende und von der Signalempfangseinrichtung detektierte Strahlung analysiert werden, so dass bereits in dem erfindungsgemäßen explosionsgeschützten Gerät eine teilweise oder vollständige Auswertung der empfangenen Strahlung erfolgt. Dies hat den Vorteil, dass eine durch die Auswertung erreichte Datenreduktion schon in dem erfindungsgemäßen explosionsgeschützten Gerät erfolgt, wodurch die Ausgabe der aus der detektierten Strahlung extrahierten Information über beispielsweise ein Display direkt am erfindungsgemäßen explosionsgeschützten Gerät erfolgen kann.

Gemäß einer weiteren bevorzugten Weiterbildung der Erfindung ist vorgesehen, dass das explosionsgeschützte Gerät ein Feldgerät, insbesondere ein Durchflussmessgerät, ein Füllstandmessgerät, ein Geigerzähler, ein Magnetfeldsensor, ein Temperaturmessgerät oder ein Photodetektor ist.

Die zuvor genannten Feldgeräte stellen eine Auswahl der besonders bevorzugten möglichen Einsatzgebiete des erfindungsgemäßen explosionsgeschützten Geräts dar. Insbesondere Füllstandmessgeräte und Durchflussmessgeräte können von der erfindungsgemäßen Lehre profitieren, da diese häufig in Bereichen mit explosionsgefährdeten Atmosphären Einsatz finden.

Bei einer vorteilhaften Ausgestaltung der Erfindung ist vorgesehen, dass das explosionsgeschützte Gerät über eine Ausgabeeinrichtung verfügt. Gemäß einer weiteren vorteilhaften Ausgestaltung der Erfindung ist vorgesehen, dass die Ausgabeeinrichtung durch eine Busschnittstelle gebildet wird.

Über eine Ausgabeeinrichtung in Form einer Busschnittstelle, eines Displays oder einer Funkverbindung können die von dem erfindungsgemäßen explosionsgeschützten Gerät gesammelten Daten oder - nach einer erfolgten Auswertung oder Vorauswertung - Informationen komfortabel und sicher ausgegeben werden.

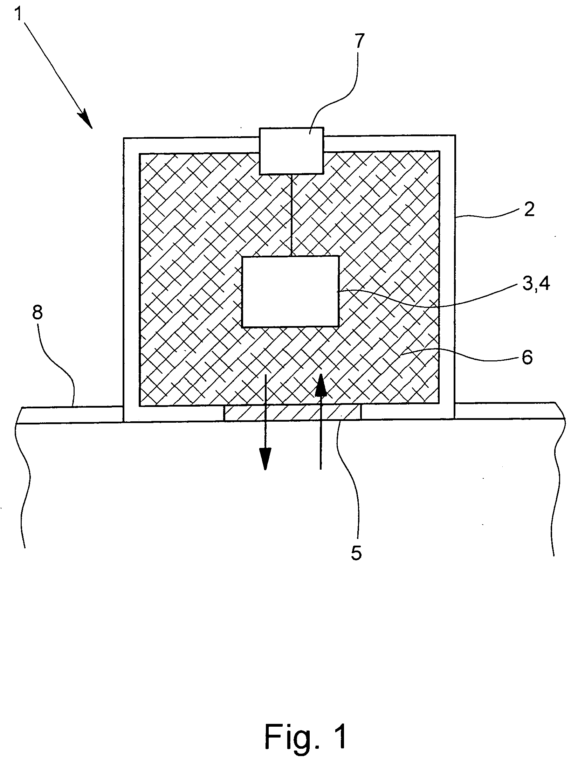

Im Einzelnen gibt es nun eine Vielzahl von Möglichkeiten, das erfindungsgemäße explosionsgeschützte Gerät auszugestalten und weiterzubilden. Dazu wird auf die dem Patentanspruch 1 nachgeordneten Patentansprüche sowie auf die nachfolgende detaillierte Beschreibung bevorzugter Ausführungsbeispiele der Erfindung unter Bezugnahme auf die Zeichnung verwiesen. In der Zeichnung zeigt
- Fig. 1: das erfindungsgemäße explosionsgeschützte Gerät.

Das in der Fig. 1 dargestellte explosionsgeschützte Gerät 1 weist eine druckfeste Kapsel 2 auf. Innerhalb der druckfesten Kapsel 2 sind eine Elektronikeinrichtung 3 und eine Signalempfangsreinrichtung 4 angeordnet. Sowohl die Elektronikeinrichtung 3 als auch die Signalempfangseinrichtung 4 sind eigensicher ausgestaltet.

In der Wandung der druckfesten Kapsel 2 ist ein strahlungsdurchlässiges Prozessfenster 5 vorgesehen. Die Elektronikeinrichtung 3 und die Signalempfangseinrichtung 4 weisen einen Verguss 6 auf. Der Verguss 6 füllt den Innenraum der druckfesten Kapsel 2 vollständig aus.

Über eine Ausgabeeinrichtung 7, die mit der Elektronikeinrichtung 3 und der Signalempfangsrichtung 4 verbunden ist, kann das explosionsgeschützte Gerät 1 Daten ausgeben. Das explosionsgeschützte Gerät 1 ist in einer Prozesstrennwand 8 integriert und befindet sich auf der prozessabgewandten Seite der Prozesstrennwand 8. Ebenso befindet sich die Ausgabeeinrichtung 7 auf der prozessabgewandten Seite des explosionsgeschützten Geräts 1.

Das strahlungsdurchlässige Prozessfenster 5 ist auf der prozesszugewandten Seite des explosionsgeschützten Geräts 1 angeordnet. Über das strahlungsdurchlässige Prozessfenster 5 findet ein Strahlungsaustausch, hier durch Pfeile gekennzeichnet, zwischen der Signalempfangseinrichtung 4 und dem Prozess statt. Um diesen Strahlungsaustausch zu gewährleisten, ist das strahlungsdurchlässige Prozessfenster 5 und die Vergussmasse des Vergusses 6, die sich zwischen dem strahlungsdurchlässigen Prozessfenster 5 und der Signalempfangseinrichtung 4 befindet, zumindest teilweise durchlässig für die zu detektierende Strahlung und ebenso durchlässig für die vom Signalerzeuger (hier nicht gesondert dargestellt) der Elektronikeinrichtung 3 erzeugten Signalstrahlung.

## Patentansprüche

1. Explosionsgeschütztes Gerät (1) mit einer druckfesten Kapsel (2), einer Elektronikeinrichtung (3) und einer Signalempfangseinrichtung (4), wobei die druckfeste Kapsel (2) ein strahlungsdurchlässiges Prozessfenster (5) aufweist und wobei die Signalempfangseinrichtung (4) und die Elektronikeinrichtung (3) innerhalb der druckfesten Kapsel (2) angeordnet sind,
**dadurch gekennzeichnet,**
**dass** die Elektronikeinrichtung (3) und die Signalempfangseinrichtung (4) eigensicher ausgebildet sind, dass die Elektronikeinrichtung (3) und/oder die Signalempfangseinrichtung (4) einen Verguss (6) aufweisen und dass der Verguss (6) den Innenraum der druckfesten Kapsel (2) zumindest teilweise als Vergusskapselung ausfüllt.

2. Explosionsgeschütztes Gerät (1) nach Anspruch 1, **dadurch gekennzeichnet, dass** das strahlungsdurchlässige Prozessfenster (5) ein Glasfenster aufweist.

3. Explosionsgeschütztes Gerät (1) nach Anspruch 2, **dadurch gekennzeichnet, dass** das Glasfenster ein metallverschmolzenes Glas aufweist.

4. Explosionsgeschütztes Gerät (1) nach einem der Ansprüche 1 bis 3,
**dadurch gekennzeichnet, dass** die Elektronikeinrichtung (3) einen Signalerzeuger und eine Signalauswerteeinrichtung aufweist.

5. Explosionsgeschütztes Gerät (1) nach einem der Ansprüche 1 bis 4,
**dadurch gekennzeichnet, dass** das explosionsgeschützte Gerät (1) ein Feldgerät, insbesondere ein Durchflussmessgerät, ein Füllstandmessgerät, ein Geigerzähler, ein Magnetfeldsensor, ein Temperaturmessgerät oder ein Photodetektor ist.

6. Explosionsgeschütztes Gerät (1) nach einem der Ansprüche 1 bis 5,
**dadurch gekennzeichnet, dass** das explosionsgeschützte Gerät (1) über eine Ausgabeeinrichtung (7) verfügt, wobei die Ausgabeeinrichtung (7) durch eine Busschnittstelle gebildet wird,

## Claims

1. Explosion-proof device (1) with a pressure-proof capsule (2), an electronic means (3) and a signal receiver (4), wherein the pressure-proof capsule (2) has a radiolucent process window (5) and wherein the signal receiver (4) and the electronic means (3) are arranged inside of the pressure-proof capsule (2)
**characterized in**
**that** the electronic means (3) and the signal receiver (4) are designed intrinsically safe, that the electronic means (3) and/or the signal receiver (4) have a casting (6), and that the casting (6) at least partially fills up the inner space of the pressure-proof capsule (2).

2. Explosion-proof device (1) according to claim 1, **characterized in that** the radiolucent process window (5) has a glass window.

3. Explosion-proof device (1) according to claim 2, **characterized in that** the glass window has metal fused glass.

4. Explosion-proof device (1) according to any one of claims 1 to 3, **characterized in that** the electronic means (3) has a signal generator and a signal-evaluating unit.

5. Explosion-proof device (1) according to any one of claims 1 to 4,
**characterized in that** the explosion-proof device (1) is a field device, in particular a flowmeter, a fill level measuring device, a Geiger counter, a magnetic field sensor, a temperature-measuring device or a photo detector.

6. Explosion-proof device (1) according to any one of claims 1 to 5,
**characterized in that** the explosion-proof device (1) has an output device (7), wherein the output device (7) is formed by a bus interface.

## Revendications

1. Appareil antidéflagrant (1) comprenant une capsule (2) à l'épreuve de la pression, un dispositif électronique (3) et un dispositif de réception de signal (4), la capsule (2) à l'épreuve de la pression possédant une fenêtre de processus (5) laissant passer le rayonnement et le dispositif de réception de signal (4) et le dispositif électronique (3) étant disposés à l'intérieur de la capsule (2) à l'épreuve de la pression,
**caractérisé en ce que**
le dispositif électronique (3) et le dispositif de réception de signal (4) sont configurés à sécurité intrinsèque, **en ce que** le dispositif électronique (3) et/ou le dispositif de réception de signal (4) possèdent un scellement (6) et **en ce que** le scellement (6) remplit l'espace intérieur de la capsule (2) à l'épreuve de la pression au moins partiellement en tant qu'encapsulation scellée.

2. Appareil antidéflagrant (1) selon la revendication 1, **caractérisé en ce que** la fenêtre de processus (5) laissant passer le rayonnement possède une fenêtre en verre.

3. Appareil antidéflagrant (1) selon la revendication 2, **caractérisé en ce que** la fenêtre en verre possède un verre fusionné avec du métal.

4. Appareil antidéflagrant (1) selon l'une des revendications 1 à 3, **caractérisé en ce que** le dispositif électronique (3) possède un générateur de signal et un dispositif d'interprétation de signal.

5. Appareil antidéflagrant (1) selon l'une des revendications 1 à 4, **caractérisé en ce que** l'appareil antidéflagrant (1) est un appareil de terrain, notamment un débitmètre, un appareil de mesure de niveau, un compteur Geiger, un capteur de champ magnétique, un appareil de mesure de température ou un photodétecteur.

6. Appareil antidéflagrant (1) selon l'une des revendications 1 à 5, **caractérisé en ce que** l'appareil antidéflagrant (1) dispose d'un dispositif de sortie (7), le dispositif de sortie (7) étant formé par une interface de bus.
